# EUROPEAN PATENT APPLICATION

(11) **EP 4 626 170 A1**
(43) Date of publication of application: **01.10.2025**
(21) Application number: 25165758.1
(22) Date of filing: 24.03.2025
(51) Int. Cl.: H10D 62/10, H10D 30/01, H10D 30/00, H10D 30/67

(54) **WITHIN STACK NANORIBBON THICKNESS TUNING FOR IMPROVED GATE-ALL-AROUND TRANSISTOR PERFORMANCE**

(30) Priority: 29.03.2024 US 202418621664
(71) Applicant: Intel Corporation, Santa Clara, CA 95054 (US)
(72) Inventor: BABB, Michael, Portland, 97227 (US); AUTH, Christopher P., Portland, 97229 (US); GLASS, Glenn, Portland, 97229 (US); THIRTHA, Vivek, Portland, 97229 (US); SU, Chen-Yi, Portland, 97229 (US); HSU, William, Portland, 97229 (US); AHMED, Kawser, Hillsboro, 97124 (US); LIN, Chung-Hsun, Portland, 97229 (US); JORGENSEN, Kelsey, Beaverton, 97007 (US); TORRES, Rodolfo, Portland, 97209 (US); YANG, Ian, Portland, 97229 (US)
(74) Representative: 2SPL Patentanwälte PartG mbB

(57) **Abstract**

Devices, transistor structures, systems, and techniques are described herein related to gate all around field effect transistors having a stack of nanoribbons (i.e., semiconductor structures) with thicknesses that are tuned to vary across the stack. The nanoribbon source-to-drain lengths are from a source interface to a drain interface with source and drain structures, respectively, and the thickness is orthogonal to the source-to-drain lengths in alignment with the vertical stacking of the nanoribbons. The nanoribbons have differing thicknesses across the stack of nanoribbons of the field effect transistor.

## Description

### BACKGROUND

Higher performance, lower cost, increased miniaturization, and greater density of integrated circuits (ICs) are ongoing goals of the electronics industry. To maintain the pace of increasing transistor performance, for example, multi-gate transistors such as gate-all-around (GAA) or nanoribbon transistors are being deployed. In such devices, the gate structure surrounds the channel region on all sides of each nanoribbon or ribbon of semiconductor material for improved drive current, device control, and other advantages. Currently, multi-gate transistors have difficulties including non-uniformity in manufacturing the nanoribbons of the transistor device. It is with respect to these and other considerations that the present improvements have been needed. Such improvements may become critical as the desire to deploy multi-gate transistor structures becomes more widespread.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A provides an isometric view of selected components of an example transistor structure having tuned semiconductor structure thicknesses;
FIG. 1B provides a cross-sectional side view of the transistor structure of FIG. 1A taken along a source-to-drain cut;
FIG. 2 illustrates a cross-sectional side view of a transistor structure similar to the transistor structure of FIGS. 1A and 1B with a lower-most semiconductor structure having an increased thickness relative to other semiconductor structures of a stack of semiconductor structures;
FIG. 3 illustrates a cross-sectional side view of a transistor structure with a second-to-lower-most semiconductor structure having an increased thickness relative to other semiconductor structures of a stack of semiconductor structures;
FIG. 4 illustrates a cross-sectional side view of a transistor structure with two top-most most semiconductor structures having increased thicknesses relative to other semiconductor structures of a stack of semiconductor structures;
FIG. 5 illustrates a cross-sectional side view of a transistor structure with a semiconductor structure with a longer source-to-drain length having an increased thickness relative to other semiconductor structures of a stack of transistor structures;
FIG. 6 illustrates a cross-sectional side view of a transistor structure with a semiconductor structure with a shorter source-to-drain length having an increased thickness relative to other semiconductor structures of a stack of transistor structures;
FIG. 7 illustrates a cross-sectional side view of another transistor structure with a lower-most semiconductor structure having an increased thickness relative to other semiconductor structures of stack of semiconductor structures;
FIG. 8 illustrates a cross-sectional side view of a transistor structure with two lower-most semiconductor structures having an increased thickness relative to other semiconductor structures of stack of semiconductor structures;
FIG. 9 is a flow diagram illustrating exemplary methods for forming transistor structures with a stack of semiconductor structures having tuned thicknesses;
FIGS. 10, 11, 12, 13, 14, and 15 are cross-sectional side views of example transistor structures as particular fabrication operations of the methods of FIG. 9 are performed;
FIG. 16 illustrates a cross-sectional side view of a transistor structure having a stack of semiconductor structures with tuned thicknesses incorporated in an integrated circuit die;
FIG. 17 illustrates exemplary systems employing an integrated circuit assembly including an integrated circuit die having a transistor structure with a stack of semiconductor structures with tuned thicknesses; and
FIG. 18 is a functional block diagram of an electronic computing device, all in accordance with at least some embodiments of the present disclosure.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

Reference is made in the following detailed description to the accompanying drawings, which form a part hereof, wherein like numerals may designate like parts throughout to indicate corresponding or analogous elements. It will be appreciated that for simplicity and/or clarity of illustration, elements illustrated in the figures have not necessarily been drawn to scale. For example, the dimensions of some of the elements may be exaggerated relative to other elements for clarity. Further, it is to be understood that other embodiments may be utilized, and structural and/or logical changes may be made without departing from the scope of claimed subject matter. It should also be noted that directions and references, for example, up, down, top, bottom, over, under, and so on, may be used to facilitate the discussion of the drawings and embodiments and are not intended to restrict the application of claimed subject matter. Therefore, the following detailed description is not to be taken in a limiting sense and the scope of claimed subject matter defined by the appended claims and their equivalents.

In the following description, numerous details are set forth. However, it will be apparent to one skilled in the art, that the present invention may be practiced without these specific details. In some instances, well-known methods and devices are shown in block diagram form, rather than in detail, to avoid obscuring the present invention. Reference throughout this specification to "an embodiment" or "one embodiment" means that a particular feature, structure, function, or characteristic described in connection with the embodiment is included in at least one embodiment of the invention. Thus, the appearances of the phrase "in an embodiment" or "in one embodiment" in various places throughout this specification are not necessarily referring to the same embodiment of the invention. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description of the invention and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items. Herein, the term "predominantly" indicates not less than 50% of a particular material or component while the term "substantially pure" indicates not less than 99% of the particular material or component and the term "pure" indicates not less than 99.9% of the particular material or component. Unless otherwise indicated, such material percentages are based on atomic percentage. Herein the term concentration is used interchangeably with material percentage and also indicates atomic percentage unless otherwise indicated.

The terms "coupled" and "connected," along with their derivatives, may be used herein to describe structural relationships between components. It should be understood that these terms are not intended as synonyms for each other. Rather, in particular embodiments, "connected" may be used to indicate that two or more elements are in direct physical or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause an effect relationship, an electrical relationship, a functional relationship, etc.).

The terms "over," "under," "between," "on", and/or the like, as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening features. The term immediately adjacent indicates such features are in direct contact. Furthermore, the terms "substantially," "close," "approximately," "near," and "about," generally refer to being within +/- 10% of a target value. The term layer as used herein may include a single material or multiple materials. As used in throughout this description, and in the claims, a list of items joined by the term "at least one of" or "one or more of" can mean any combination of the listed terms. For example, the phrase "at least one of A, B or C" can mean A; B; C; A and B; A and C; B and C; or A, B and C. The terms "lateral", "laterally adjacent" and similar terms indicate two or more components are aligned along a plane orthogonal to a vertical direction of an overall structure. As used herein, the terms "monolithic", "monolithically integrated", and similar terms indicate the components of the monolithic overall structure form an indivisible whole not reasonably capable of being separated.

Devices, transistor structures, integrated circuit dies, apparatuses, systems, and techniques are described herein related to gate-all-around field effect transistors (GAA-FETs) having a stack of semiconductor structures with tuned thicknesses.

As discussed, multi-gate transistors such as gate-all-around (GAA) or nanoribbon transistors are being deployed in advanced integrated circuit devices. As used herein, the terms nanowire, nanoribbon, stacked semiconductor structure, and similar terms are used substantially interchangeably to indicate a semiconductor material that extends from a source to a drain such that the semiconductor material is one of two or more such materials that are separated and vertically aligned. The multiple semiconductor material each couple to the same source and drain, and are separated by a gate structure, which may include a gate dielectric and a gate electrode. Thereby, the field effect transistor or device includes a source, a drain, and a stack of semiconductor structures extending between the source and the drain. The stack of semiconductor structures (e.g., two to about eight semiconductor structures) are controlled by the same gate electrode, and work in concert as the channel of the device. As used herein, the term channel region of a semiconductor structure indicates a region of a material layer adjacent to a gate dielectric and gate electrode that is to be controlled by the gate electrode to switch the transistor structure in operation. Notably, a region of a material layer need not be in operation to be characterized as a channel region, channel material, or the like. The term semiconductor structure is used broadly to include nanowires, nanoribbons, and similar terms.

Current GAA-FETs have difficulties including non-uniformity in fabricating the semiconductor structures of the transistor device. Notably, the distance along the semiconductor structures from the source to the drain (i.e., a source-to-drain length) may be non-uniform in the stack of semiconductor structures. That is, when patterned (e.g., using lithography and one or more etch processes), the resultant semiconductor structures having differing lengths in the x-y plane orthogonal to the vertical (i.e., z-dimension) of the stack. This defines the source-to-drain length as the source and drain structures are then formed by epitaxial growth from the patterned semiconductor structures. Due to the non-uniform semiconductor structure source-to-drain lengths, assuming the same thicknesses and other properties of the semiconductor structures, there is a difference in channel resistance and other electrical properties of the semiconductor structures (e.g., nanoribbons). The techniques discussed herein optimize the performance of the GAA-FETs by varying the thicknesses of the semiconductor structure across the stack of semiconductor structure. In some embodiments, this may be in response to the discussed source-to-drain length variation. However, thickness variation may be used in devices with semiconductor structures having the same source-to-drain lengths. In some embodiments, the discussed non-uniformity of semiconductor structure source-to-drain lengths is predictable and repeatable based on the processes used to form them. By pre-defining the thicknesses of the semiconductor structures and subsequent patterning, the thicknesses and corresponding source-to-drain lengths can then be predictably and repeatably formed to tune the resultant device. In some embodiments, the thicknesses are tuned to reduce channel resistance of the device by, for example, providing a greater thickness for the one or more semiconductor structures that have longer source-to-drain length(s). However, the GAA-FETs may be advantageously tuned for improved electrical performance using any combination of thicknesses, as discussed further herein.

In some embodiments, a superlattice of alternating layers of silicon (i.e., nanoribbon material) and silicon germanium (i.e., sacrificial layers) are formed. The thicknesses of the silicon layers may be tuned based on expected source-to-drain lengths of the eventual nanoribbons being fabricated and/or based on desired electrical properties of the eventual transistor device. The silicon layer thicknesses may be tuned using any suitable technique or techniques such as adjusting the deposition times and conditions used when forming the silicon layers. The superlattice is then patterned with the resultant source-to-drain lengths being defined and advantageously corresponding to the pre-defined silicon layer thicknesses. Processing continues with the formation of the GAA-FETs by, for example, epitaxial growth of source and drain, nanoribbon release by removal of the silicon germanium sacrificial layers, and formation of gate structures. During such processing the source-to-drain lengths and thicknesses are substantially maintained, and the resultant devices have the discussed advantageous electrical characteristics due to the silicon layer thickness tuning established during superlattice growth. Although discussed here with respect to alternating layers of silicon and silicon germanium, any suitable channel semiconductor materials and sacrificial materials may be used.

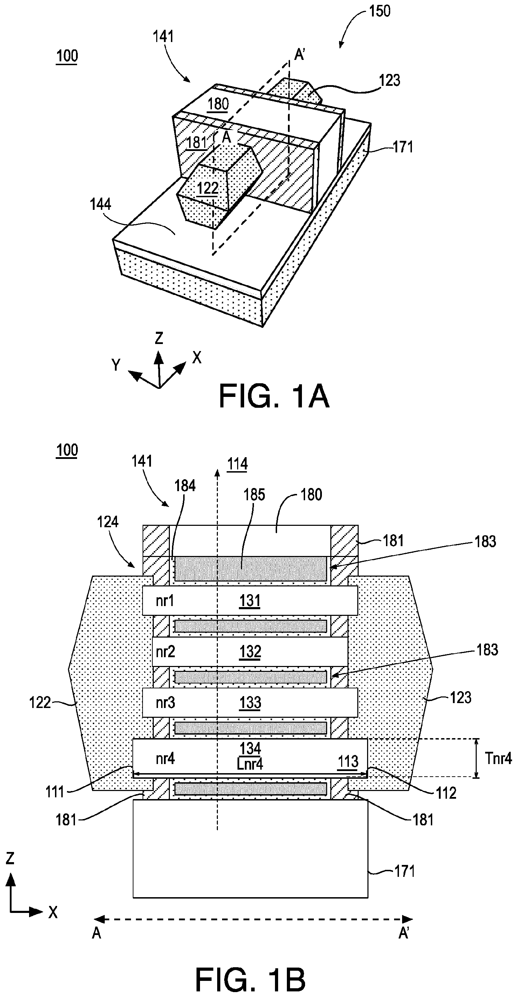

FIGS. 1A and 1B illustrate views of components of an exemplary transistor structure 100 having tuned semiconductor structure thicknesses, in accordance with at least some embodiments of the present disclosure. FIG. 1A provides an isometric view of selected components of an example transistor structure 100 having tuned semiconductor structure thicknesses, and FIG. 1B provides a cross-sectional side view of transistor structure 100 taken along a source-to-drain cut (which is also characterized as a fin cut as it extends along a fin formed during fabrication of transistor structure 100). As shown, the source-to-drain cut illustrated in FIG. 1B is taken along the A-A' plane of FIG. 1A. Transistor structure 100 may be part of a device layer of a monolithic integrated circuit die 150, which is incorporated in an electronic device as discussed further herein.

As shown, transistor structure 100 includes a source structure 122, a drain structure 123, and a gate structure 141, which may be formed over a substrate 171 and partially within a dielectric material 144. Notably, the illustration of transistor structure 100 provides exemplary components and partial fabrication for the sake of clarity of presentation. As shown in the cross-section of FIG. 1B, gate structure 141 may include isolation material 181, gate structures 183, and a gate contact including a material 180 such as polysilicon. In some embodiments, material 180 may be removed or not employed. As further shown in the cross-section of FIG. 1B, gate structures 183 may be wrap around gate contacts that include a gate dielectric layer 184 immediately adjacent a stack 124 of semiconductor structures 131, 132, 133, 134 (e.g., wrapping around adjacent semiconductor structures 131, 132, 133, 134) and a gate electrode 185 on gate dielectric layer 184.

Each of semiconductor structures 131, 132, 133, 134 of stack 124 may be labeled from the top of stack 124 toward the bottom of stack 124 as shown with respect to labels nr1, nr2, nr3, nr4, using an abbreviation of nanowire for the sake of clarity and convenience. As shown with respect to semiconductor structure 134, each of semiconductor structures 131, 132, 133, 134 of stack 124 has a source-to-drain length (LnrX) and a thickness (TnrX). The source-to-drain length (LnrX) and thickness (TnrX) of each of semiconductor structures 131, 132, 133, 134 of stack 124 are illustrated and discussed further herein below but are not shown in FIG. 1B for the sake of clarity of presentation. In some embodiments, each source-to-drain lengths (LnrX) are the same and one or more of thicknesses (TnrX) are varied (e.g., by a delta of three angstroms or more) to tune transistor structure 100. In some embodiments, one or more of source-to-drain lengths (LnrX) are different and one or more of thicknesses (TnrX) are varied (e.g., by a delta of three angstroms or more) to tune transistor structure 100 based in part on the differing source-to-drain lengths (LnrX).

In some embodiments, source structure 122 and drain structure 123 are epitaxial to stack 124 of semiconductor structures 131, 132, 133, 134. However, source structure 122 and drain structure 123 may be formed using any suitable technique or techniques and may include any suitable materials. In any case, each of semiconductor structures 131, 132, 133, 134 has a source-to-drain length that extends from an interface 111 with source structure 122 to an interface 112 with drain structure 123, as illustrated with respect to semiconductor structure 134. As used herein, the term interface indicates a location of transition from one material or structure to another. As illustrated with respect to semiconductor structure 134, the source-to-drain length extends from interface 111 to interface 112 in a source-to-drain direction 113 orthogonal to a vertical dimension 114 of the device.

Herein, vertical dimension 114 and source-to-drain direction 113 are used in their ordinary meaning such that vertical dimension 114 is orthogonal to an x-y plane of a work surface of substrate 171 (e.g., a wafer), and is in a front-side build up direction of transistor structure 100. Source-to-drain direction 113 is in the x-y plane and therefore orthogonal to vertical dimension 114. Furthermore, source-to-drain direction 113 extends, in the illustrated context, in the x-dimension from source structure 122 to drain structure 123. In some embodiments, source-to-drain direction 113 extends along a fin structure of transistor structure 100, along a centerline of the channel of transistor structure 100, or the like as is known in the art. In some embodiments, source-to-drain direction 113 extends along a direction from a centroid of source structure 122 to drain structure 123. The source-to-drain lengths LnrX are defined by the distance between source structure 122 and drain structure 123 through the channel of each of semiconductor structures 131, 132, 133, 134.

Furthermore, each of semiconductor structures 131, 132, 133, 134 of stack 124 has a thickness (TnrX) which is again illustrated with respect to semiconductor structure 134 (Tnr4). Thickness Tnr4 is in vertical dimension 114, and thickness Tnr4 (along with each of thicknesses TnrX) may be determined using any suitable technique or techniques. In some embodiments, thicknesses TnrX are determined by measurement at a centerpoint of each of semiconductor structures 131, 132, 133, 134. In some embodiments, thicknesses TnrX are determined by measurement at multiple locations of each of semiconductor structures 131, 132, 133, 134 and taking a mean or median of the resultant measurements. In some embodiments, thicknesses TnrX across multiple instances of each of semiconductor structures 131, 132, 133, 134 (e.g., at a centerpoint of each or at multiple points of each nanoribbon of many transistor structures 100) are taken and the resulting mean or median may be used as thicknesses TnrX. Other techniques may be used.

As discussed further herein below, thicknesses TnrX are tuned to improve the performance of transistor structure. In some embodiments, thicknesses TnrX are tuned with equal source-to-drain lengths LnrX of semiconductor structures 131, 132, 133, 134. In some embodiments, thicknesses TnrX are tuned based on the predictable resulting source-to-drain lengths LnrX that are used to fabricate stack 124 of semiconductor structures 131, 132, 133, 134. As discussed, source-to-drain lengths LnrX of semiconductor structures 131, 132, 133, 134 may not be uniform across stack 124 but may be predictable and reliable (i.e., predictably different based on fabrication). As shown in FIG. 1B, in some embodiments, a thickness of the bottom-most semiconductor structure 134 has a greater thickness Tnr4 that is tuned to be thicker in response to the source-to-drain length Lnr4 of semiconductor structure 134 being the longest of stack 124. That is, semiconductor structure 134 may be repeatedly fabricated to be longer than semiconductor structures 131, 132, 133, and in response thereto, thickness Tnr4 may be tuned to be thicker than the thickness of any of semiconductor structures 131, 132, 133. As used herein, the terms bottom-most and top-most indicate the last semiconductor structure of stack 124 with the bottom-most being adjacent a substrate, a subfin, and similar features and the top-most being adjacent frontside metallization and similar features.

As shown, transistor structure 100 includes a source (e.g., source structure 122) and a drain (e.g., drain structure 123), stack 124 of semiconductor structures 131, 132, 133, 134 extending between source structure 122 and drain structure 123, such that semiconductor structures 131, 132, 133, 134 have corresponding source-to-drain lengths Lnr1, Lnr2, Lnr3, Lnr4 and thicknesses Tnr1, Tnr2, Tnr3, Tnr4. In some embodiments, thicknesses Tnr1, Tnr2, Tnr3, Tnr4 are tuned such that one of thicknesses Tnr1, Tnr2, Tnr3, Tnr4 is not less than three angstroms less than or greater than any other of thicknesses Tnr1, Tnr2, Tnr3, Tnr4 by a thickness delta Td. Such tuning may be for equal source-to-drain lengths Lnr1, Lnr2, Lnr3, Lnr4. In some embodiments, source-to-drain lengths Lnr1, Lnr2, Lnr3, Lnr4 are equal and semiconductor structure 134 has a thickness Tnr4 that is not less than 3 angstroms (i.e., Td) greater than any of thicknesses Tnr1, Tnr2, Tnr3. However, any of thicknesses Tnr1, Tnr2, Tnr3, Tnr4 may be greater than or less than all or some of the others of thicknesses Tnr1, Tnr2, Tnr3, Tnr4 by any thickness delta Td discussed herein.

In some embodiments, certain source-to-drain lengths are greater than others and, correspondingly, thicknesses Tnr1, Tnr2, Tnr3, Tnr4 may be increased by thickness delta Td. In some embodiments, semiconductor structure 134 has a source-to-drain length Lnr4 greater than any of source-to-drain lengths Lnr1, Lnr2, Lnr3 and semiconductor structure 134 has a thickness Tnr4 that is not less than 3 angstroms (i.e., Td) greater than any of thicknesses Tnr1, Tnr2, Tnr3. Transistor structure 100 further includes gate structure 183 adjacent and between semiconductor structures 131, 132, 133, 134 of stack 124.

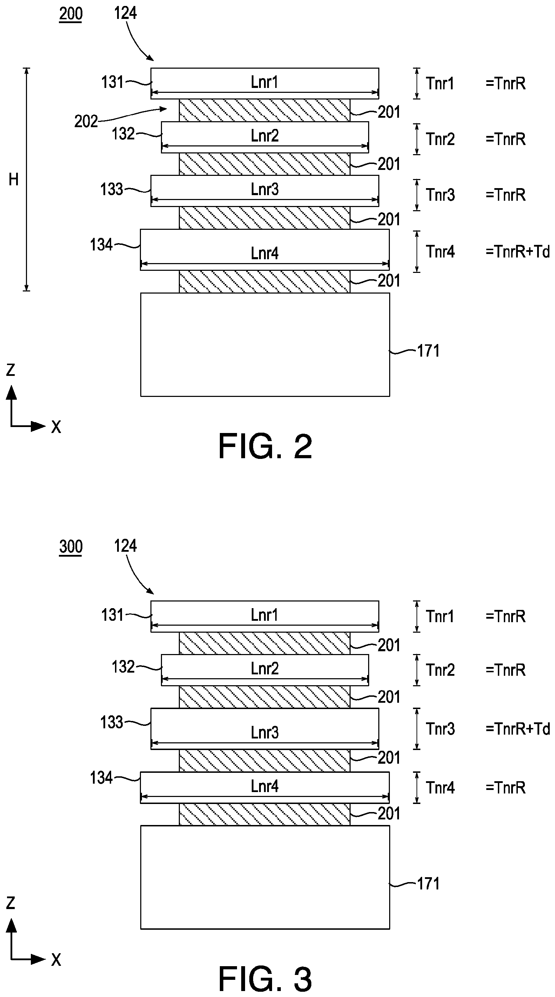

Discussion now turns to various embodiments of source-to-drain lengths LnrX and tuned thicknesses of semiconductor structures of stack 124. In the illustrations of FIGS. 2-8, only semiconductor structures such as semiconductor structures 131, 132, 133, 134, substrate 171, and intervening sacrificial layers are illustrated for the sake of clarity of presentation. However, any of the components of transistor structures discussed with respect to FIGS. 2-8 may be deployed in transistor structure 100 and other transistor structures, devices, and systems discussed herein.

FIG. 2 illustrates a cross-sectional side view of a transistor structure 200 similar to transistor structure 100 with a lower-most semiconductor structure having an increased thickness relative to other semiconductor structures of stack 124 of semiconductor structures 131, 132, 133, 134, in accordance with at least some embodiments of the present disclosure. Notably, the source-to-drain lengths Lnr1, Lnr2, Lnr3, Lnr4 and thicknesses Tnr1, Tnr2, Tnr3, Tnr4 of semiconductor structures 131, 132, 133, 134 of transistor structure 200 match those of transistor structure 100. Transistor structure 200, and those discussed with respect to FIGS. 3-8 illustrate semiconductor structures 131, 132, 133, 134 separated by sacrificial layers 201. In some embodiments, semiconductor structures 131, 132, 133, 134 are silicon or include silicon and sacrificial layers 201 are silicon germanium or include silicon and germanium. Transistor structure 200 may be arrived at by forming interleaved planar layers of semiconductor structures 131, 132, 133, 134 and sacrificial layers 201, and patterning and etching the interleaved planar layers into a fin structure, as illustrated further herein below. In some embodiments, the patterning and etching includes at least a fin defining etch and a recess etch that forms recesses 202. In some embodiments, the fin defining etch includes multiple etch processes. Such patterning and etching, as discussed, predictably forms semiconductor structures 131, 132, 133, 134 having differing source-to-drain lengths Lnr1, Lnr2, Lnr3, Lnr4.

In some embodiments, source-to-drain lengths Lnr1, Lnr2, Lnr3, Lnr4 are in the range of 5 to 20 nm, however any suitable source-to-drain lengths Lnr1, Lnr2, Lnr3, Lnr4 may be deployed. In some embodiments, bottom-most semiconductor structure 134 has a greater source-to-drain length Lnr4 than any of source-to-drain lengths Lnr1, Lnr2, Lnr3. In some embodiments, bottom-most semiconductor structure 134 has a greatest source-to-drain length Lnr4 that is not less than 5% greater than any of source-to-drain lengths Lnr1, Lnr2, Lnr3. In some embodiments, bottom-most semiconductor structure 134 has a greatest source-to-drain length Lnr4 that is not less than 10% greater than any of source-to-drain lengths Lnr1, Lnr2, Lnr3. In some embodiments, bottom-most semiconductor structure 134 has a greatest source-to-drain length Lnr4 that is not less than 20% greater than any of source-to-drain lengths Lnr1, Lnr2, Lnr3. Other lengths and multiples may be observed.

Furthermore, as shown, the discussed patterning and etching may provide a profile of source-to-drain lengths Lnr1, Lnr2, Lnr3, Lnr4 that has source-to-drain length Lnr1 being the longest, source-to-drain length Lnr2 being the shortest, and source-to-drain length Lnr3 increasing to a length similar to that of source-to-drain length Lnr1. However, other profiles may be formed depending on the patterning and etch techniques deployed.

In the context of transistor structure 200, source-to-drain length Lnr4 being substantially longer than any of source-to-drain lengths Lnr1, Lnr2, Lnr3 may cause semiconductor structure 134 to have a greatest resistance from source structure 122 to drain structure 123 (refer to FIG. 1B). Therefore, semiconductor structure 134 may not carry an equal share of current relative to semiconductor structures 131, 132, 133 when the resultant device is on. Therefore, to tune performance, thickness Tnr4 is increased relative to some or all of semiconductor structures 131, 132, 133. In the example of FIG. 2, thickness Tnr4 is increased over a reference thickness TnrR by a thickness delta Td. For example, each of semiconductor structures 131, 132, 133 may have a thickness of TnrR (i.e., Tnr1=Tnr2=Tnr3=TnrR) and semiconductor structure 134 has a thickness of Tnr4 (i.e., Tnr4=TnrR+Td) such that thickness Tnr4 is not less than 3 angstroms greater than each of thicknesses Tnr1, Tnr2, Tnr3. However, thicknesses Tnr1, Tnr2, Tnr3 may also be different from one another.

In some embodiments, the reference thickness TnrR is in the range of about 75 to 100 angstroms. In some embodiments, the reference thickness TnrR is not less than 75 and not more than 100 angstroms. In some embodiments, the reference thickness TnrR is not less than 85 and not more than 95 angstroms. In some embodiments, the reference thickness TnrR is not less than 85 and not more than 90 angstroms. However, other target thicknesses may be used.

As discussed, in some embodiments, thickness Tnr4 is not less than 3 angstroms greater than each of thicknesses Tnr1, Tnr2, Tnr3. For example, thickness delta Td may be not less than 3 angstroms. In some embodiments, thickness Tnr4 is not less than 5 angstroms greater than each of thicknesses Tnr1, Tnr2, Tnr3. In some embodiments, thickness Tnr4 is not less than 7 angstroms greater than each of thicknesses Tnr1, Tnr2, Tnr3. In some embodiments, thickness Tnr4 is not less than 3 angstroms and not more than 12 angstroms greater than each of thicknesses Tnr1, Tnr2, Tnr3. In some embodiments, thickness Tnr4 is not less than 3 angstroms and not more than 15 angstroms greater than each of thicknesses Tnr1, Tnr2, Tnr3. In some embodiments, thickness Tnr4 is not less than 5 angstroms and not more than 10 angstroms greater than each of thicknesses Tnr1, Tnr2, Tnr3. Other thickness deltas Td may be used; however, it is noted that thickness deltas Td of less than 3 angstroms are unlikely to significantly impact electrical performance while thickness deltas Td of greater than 15 angstroms offer little additional electrical performance impacts over smaller thickness deltas Td.

In some embodiments, thickness delta Td, whether added to one or more of thicknesses Tnr1, Tnr2, Tnr3, Tnr4 (as shown) or subtracted from one or more of thicknesses Tnr1, Tnr2, Tnr3, Tnr4 may be about 3% to 20% of the illustrated reference thickness TnrR. In some embodiments, thickness delta Td is not less than 3% of reference thickness TnrR. In some embodiments, thickness delta Td is not less than 5% of reference thickness TnrR. In some embodiments, thickness delta Td is not less than 10% of reference thickness TnrR. In some embodiments, thickness delta Td is not less than 15% of reference thickness TnrR. In some embodiments, thickness delta Td is not less than 3% of reference thickness TnrR and not more than 20% of reference thickness TnrR.

Tnr4 is not less than 5 angstroms greater than each of thicknesses Tnr1, Tnr2, Tnr3. In some embodiments, thickness Tnr4 is not less than 7 angstroms greater than each of thicknesses Tnr1, Tnr2, Tnr3. In some embodiments, thickness Tnr4 is not less than 3 angstroms and not more than 12 angstroms greater than each of thicknesses Tnr1, Tnr2, Tnr3. In some embodiments, thickness Tnr4 is not less than 3 angstroms and not more than 15 angstroms greater than each of thicknesses Tnr1, Tnr2, Tnr3. Other thickness deltas Td may be used. In some embodiments, thickness Tnr4 is not less than 5 angstroms and not more than 10 angstroms greater than each of thicknesses Tnr1, Tnr2, Tnr3. Other thickness deltas Td may be used, however, it is noted that thickness deltas Td of less than 3 angstroms are unlikely to significantly impact electrical performance while thickness deltas Td of greater than 15 angstroms offer little additional electrical performance impacts over smaller thickness deltas Td.

As discussed, thickness Tnr4 may be increased relative to that of thicknesses Tnr1, Tnr2, Tnr3 due to source-to-drain length Lnr4 being greater than those of source-to-drain length Lnr1, Lnr2, Lnr3. However, any tuning may be deployed herein. In some embodiments, one or more longer length semiconductor structures 131, 132, 133, 134 may have increased thicknesses. In other embodiments, one or more shorter length semiconductor structures 131, 132, 133, 134 may have increased thicknesses. This depends on the type of tuning that is desired in the transistor structure. For example, while increasing the thickness of one or more of semiconductor structures 131, 132, 133, 134 can increase device current, such thickness increases increase the overall height H, which increases device capacitance (disadvantageously increasing power consumption), and can disadvantageously increase leakage current, and cause other difficulties. Therefore, device performance tuning can be done by increasing particular ones of thicknesses Tnr1, Tnr2, Tnr3, Tnr4, or decreasing particular ones of thicknesses Tnr1, Tnr2, Tnr3, Tnr4, or both.

FIG. 3 illustrates a cross-sectional side view of a transistor structure 300 with a second-to-lower-most semiconductor structure having an increased thickness relative to other semiconductor structures of stack 124 of semiconductor structures 131, 132, 133, 134, in accordance with at least some embodiments of the present disclosure. As discussed, components of transistor structure 300 may be arrived at by forming interleaved planar layers of semiconductor structures 131, 132, 133, 134 and sacrificial layers 201, and patterning and etching the interleaved planar layers into a fin structure such that the patterning and etching predictably forms semiconductor structures 131, 132, 133, 134 having differing source-to-drain lengths Lnr1, Lnr2, Lnr3, Lnr4. Source-to-drain lengths Lnr1, Lnr2, Lnr3, Lnr4 may be any lengths discussed herein. Notably, source-to-drain lengths Lnr1, Lnr2, Lnr3, Lnr4 may be the same or similar to those discussed with respect to transistor structure 200.

In the context of transistor structure 300, source-to-drain length Lnr3 being substantially longer than other source-to-drain to lengths such as, for example, source-to-drain length Lnr2 may cause semiconductor structure 133 to have a greater resistance from source structure 122 to drain structure 123 (refer to FIG. 1B) than is desirable. Furthermore, since semiconductor structure 133 is not the bottom-most semiconductor structure, increasing its thickness may not contribute to device leakage as much as increasing the thickness of semiconductor structure 134. Therefore, to tune performance, thickness Tnr3 is increased relative to some or all of semiconductor structures 131, 132, 134. In some embodiments, thickness Tnr3 is increased by thickness delta Td relative to reference thickness TnrR. For example, each of semiconductor structures 131, 132, 134 may have a thickness of TnrR (i.e., Tnr1=Tnr2=Tnr4=TnrR) and semiconductor structure 133 has a thickness of Tnr4 (i.e., Tnr3=TnrR+Td) such that thickness Tnr3 is not less than 3 angstroms greater than each of thicknesses Tnr1, Tnr2, Tnr3. However, thicknesses Tnr1, Tnr2, Tnr4 may also be different from one another.

In some embodiments, source-to-drain length Lnr3 is within 3% of source-to-drain length Lnr1, and source-to-drain length Lnr3 is not less than 5% greater than source-to-drain length Lnr2. In some embodiments, source-to-drain length Lnr3 is not less than 10% greater than source-to-drain length Lnr2. In some embodiments, source-to-drain length Lnr4 is the longest source-to-drain length and source-to-drain length Lnr4 is not less than 5% greater than source-to-drain length Lnr3. As discussed, in some embodiments, source-to-drain lengths Lnr1, Lnr2, Lnr3, Lnr4 are in the range of 5 to 20 nm. Furthermore, the discussed patterning and etching may provide a profile of source-to-drain lengths Lnr1, Lnr2, Lnr3, Lnr4 that has source-to-drain length Lnr1 being the longest, source-to-drain length Lnr2 being the shortest, and source-to-drain length Lnr3 increasing to a length similar to that of source-to-drain length Lnr1, as discussed with respect to FIG. 2.

Reference thickness TnrR may be any value discussed herein above, as may thickness delta Td. Similarly, the ratio of thickness delta Td to reference thickness TnrR may be any value discussed above. In some embodiments, thickness Tnr3 is not less than 3 angstroms greater than each of thicknesses Tnr1, Tnr2, Tnr4. In some embodiments, thickness Tnr3 is not less than 5 angstroms greater than each of thicknesses Tnr1, Tnr2, Tnr4. In some embodiments, thickness Tnr3 is not less than 7 angstroms greater than each of thicknesses Tnr1, Tnr2, Tnr4. In some embodiments, thickness Tnr3 is not less than 3 angstroms and not more than 12 angstroms greater than each of thicknesses Tnr1, Tnr2, Tnr4. In some embodiments, thickness Tnr3 is not less than 3 angstroms and not more than 15 angstroms greater than each of thicknesses Tnr1, Tnr2, Tnr4. In some embodiments, thickness Tnr3 is not less than 5 angstroms and not more than 10 angstroms greater than each of thicknesses Tnr1, Tnr2, Tnr4.

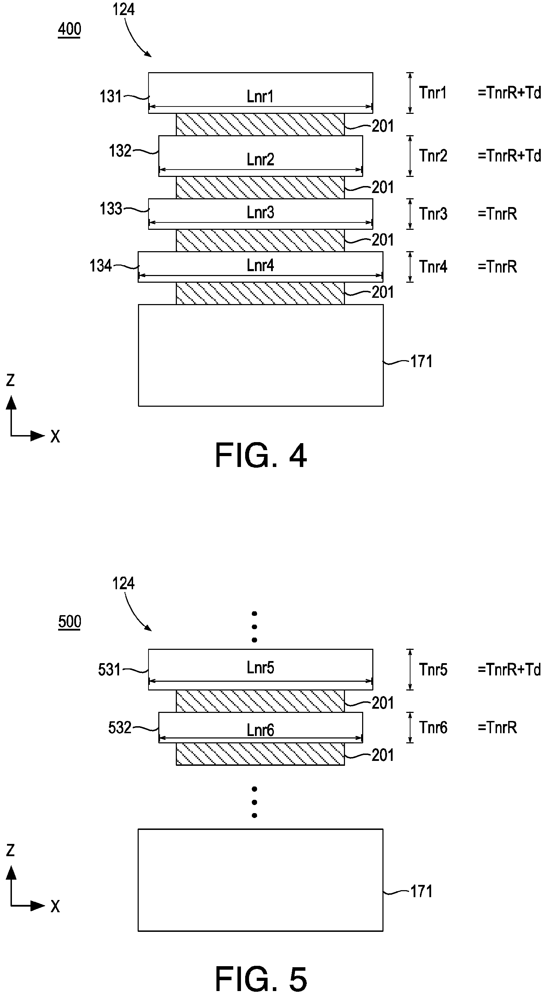

FIG. 4 illustrates a cross-sectional side view of a transistor structure 400 with two top-most most semiconductor structures having increased thicknesses relative to other semiconductor structures of stack 124 of semiconductor structures 131, 132, 133, 134, in accordance with at least some embodiments of the present disclosure. As discussed, components of transistor structure 400 may be arrived at by forming interleaved planar layers of semiconductor structures 131, 132, 133, 134 and sacrificial layers 201, and patterning and etching the interleaved planar layers into a fin structure. Source-to-drain lengths Lnr1, Lnr2, Lnr3, Lnr4 may be any lengths discussed herein. Notably, source-to-drain lengths Lnr1, Lnr2, Lnr3, Lnr4 may be the same or similar to those discussed with respect to transistor structures 200, 300. For example, transistor structures 200, 300, 400 may have the same or similar source-to-drain length profiles.

In the context of transistor structure 400, source-to-drain lengths Lnr3, Ln4 being longer than other source-to-drain to lengths such as, for example, source-to-drain length Lnr2 may cause transistor structure 400 overall to have a greater resistance from source structure 122 to drain structure 123 (refer to FIG. 1B) than is desirable. Furthermore, since semiconductor structures 131, 132 are at the top of stack 124, increasing the thicknesses of semiconductor structures 131, 132 may not contribute to device leakage as much as increasing the thickness of semiconductor structures 133, 134. Therefore, to tune performance, thicknesses Tnr1, Tnr2 are increased relative to semiconductor structures 133, 134. In some embodiments, thicknesses Tnr1, Tnr2 are increased by thickness delta Td relative to reference thickness TnrR. For example, each of semiconductor structures 133, 134 may have a thickness of TnrR (i.e., Tnr3=Tnr4=TnrR) and semiconductor structures 131, 132 have thicknesses of Tnr1, Tnr2 (i.e., Tnr1=Tnr2=TnrR+Td) such that thicknesses Tnr1, Tnr2 are not less than 3 angstroms greater than each of thicknesses Tnr3, Tnr4. In some embodiments, thicknesses of Tnr1, Tnr2 may be different from one another such that each are larger than thicknesses Tnr3, Tnr4 by not less than 3, 5, or 7 angstroms, for example.

Reference thickness TnrR, thickness delta Td, and the ratio of thickness delta Td to reference thickness TnrR may be any value discussed above. In some embodiments, thicknesses Tnr1, Tnr2 are not less than 3 angstroms greater than each of thicknesses Tnr3, Tnr4. In some embodiments, thicknesses Tnr1, Tnr2 are not less than 5 angstroms greater than each of thicknesses Tnr3, Tnr4. In some embodiments, thicknesses Tnr1, Tnr2 are not less than 7 angstroms greater than each of thicknesses Tnr3, Tnr4. In some embodiments, thicknesses Tnr1, Tnr2 are not less than 3 angstroms and not more than 12 angstroms greater than each of thicknesses Tnr3, Tnr4. In some embodiments, thicknesses Tnr1, Tnr2 are not less than 3 angstroms and not more than 15 angstroms greater than each of thicknesses Tnr3, Tnr4. In some embodiments, thicknesses Tnr1, Tnr2 are not less than 5 angstroms and not more than 10 angstroms greater than each of thicknesses Tnr3, Tnr4.

FIG. 5 illustrates a cross-sectional side view of a transistor structure 500 with a semiconductor structure 531 with a longer source-to-drain length having an increased thickness relative to other semiconductor structures of stack 124 of transistor structures 531, 532, in accordance with at least some embodiments of the present disclosure. In the context of FIGS. 1A, 1B, 2, 3, and 4, stacks 124 of four semiconductor structure 131, 132, 133, 134 are illustrated. However, stack 124 may have any number of semiconductor structure such as 2, 3, 6, 7, 8, or more.

As discussed, components of transistor structure 500 are formed by patterning interleaved planar layers of semiconductor materials and sacrificial layers. Source-to-drain lengths Lnr5, Lnr6 may be any lengths discussed herein with respect to source-to-drain lengths Lnr1, Lnr2, Lnr3, Lnr4. In the context of transistor structure 500, source-to-drain length Lnr5 being longer than other source-to-drain to lengths such as, for example, source-to-drain length Lnr6 may cause a greater resistance from source structure 122 to drain structure 123 (refer to FIG. 1B) than is desirable. Therefore, thickness Tnr5 is increased relative to that of thickness Tnr6, to increase the current load of semiconductor structure 531. Although illustrated with respect to semiconductor structure 531 being directly above semiconductor structure 532, semiconductor structures 531, 532 may be at any positions within stack 124.

In some embodiments, semiconductor structure 531 has a greater source-to-drain length Lnr5 than source-to-drain length Lnr6. In some embodiments, source-to-drain length Lnr5 is not less than 5% greater than source-to-drain length Lnr6. In some embodiments, source-to-drain length Lnr5 is not less than 10% greater than source-to-drain length Lnr6. In some embodiments, source-to-drain length Lnr5 is not less than 20% greater than source-to-drain length Lnr6. Other lengths and multiples may be observed. As discussed, thickness Tnr5 of semiconductor structure 531 is increased relative to thickness Tnr6 of semiconductor structure 532 to tune the performance of transistor structure 500. In some embodiments, thickness Tnr5 is increased by thickness delta Td relative to reference thickness TnrR. For example, semiconductor structure 532 may have a thickness of TnrR (i.e., Tnr6=TnrR) and semiconductor structure 531 may have a thickness of TnrR plus the thickness delta (i.e., Tnr5=TnrR+Td) such that thicknesses Tnr5 is not less than 3 angstroms greater than thickness Tnr6. In some embodiments, thicknesses Tnr5 is not less than 5 angstroms greater than thicknesses Tnr6. In some embodiments, thicknesses Tnr5 is not less than 7 angstroms greater than thicknesses Tnr6. In some embodiments, thicknesses Tnr5 is not less than 3 angstroms and not more than 12 angstroms greater than thicknesses Tnr6. In some embodiments, thicknesses Tnr5 is not less than 3 angstroms and not more than 15 angstroms greater than thicknesses Tnr6. In some embodiments, thicknesses Tnr5 is not less than 5 angstroms and not more than 10 angstroms greater than thicknesses Tnr6.

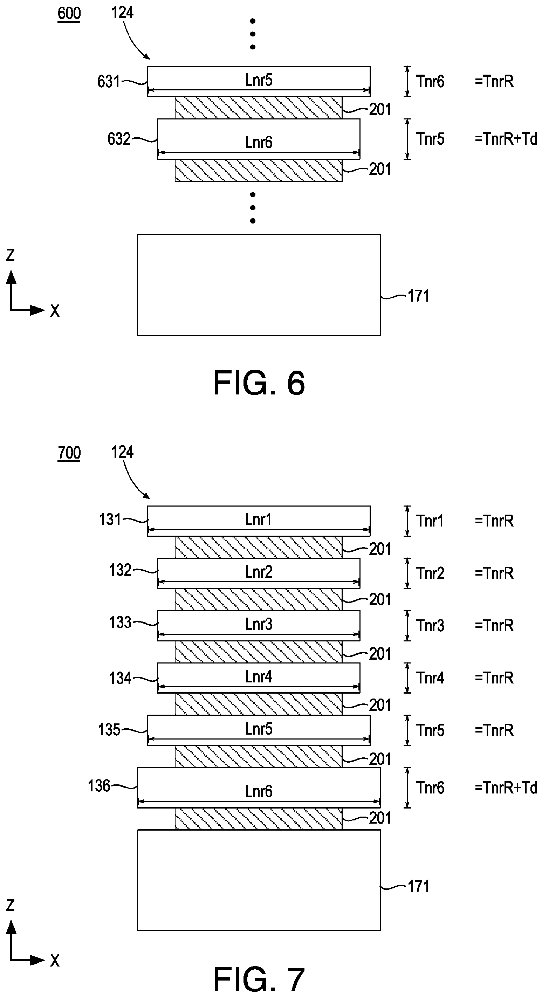

FIG. 6 illustrates a cross-sectional side view of a transistor structure 600 with a semiconductor structure 631 with a shorter source-to-drain length having an increased thickness relative to other semiconductor structures of stack 124 of transistor structures 631, 632, in accordance with at least some embodiments of the present disclosure. Transistor structure 600 illustrates the inverse relationship with respect to transistor structure 500. In the context of transistor structure 600, the shorter source-to-drain length semiconductor structure 632 may be located in a position of stack 124 (e.g., not a bottom of stack 124, or at or near a middle of stack 124) such that increasing current flow through semiconductor structure 632. For example, current may be advantageously moved within stack 124 to a position in the stack, to a longer source-to-drain length semiconductor structure, to a shorter source-to-drain length semiconductor structure, or any combination thereof, to tune the performance of the transistor structure.

Source-to-drain lengths Lnr5, Lnr6 and thicknesses Tnr5, Tnr6 may be any dimensions discussed with respect to FIG. 6. It is noted that thicknesses Tnr5, Tnr6 are switched such that the shorter source-to-drain length semiconductor structure 632 (i.e., having shorter source-to-drain length Lnr6) is paired with greater thickness Tnr5, and source-to-drain length semiconductor structure 631 (i.e., having longer source-to-drain length Lnr5) is paired with lesser thickness Tnr6. Although illustrated with respect to semiconductor structure 531 being directly above semiconductor structure 532, semiconductor structures 531, 532 may be at any positions within stack 124.

In some embodiments, semiconductor structure 631 has a greater source-to-drain length Lnr5 than source-to-drain length Lnr6 of semiconductor structure 632. In some embodiments, source-to-drain length Lnr5 is not less than 5% greater than source-to-drain length Lnr6. In some embodiments, source-to-drain length Lnr5 is not less than 10% greater than source-to-drain length Lnr6. In some embodiments, source-to-drain length Lnr5 is not less than 20% greater than source-to-drain length Lnr6. Other lengths and multiples may be observed. As discussed, thickness Tnr5 of semiconductor structure 632 is increased relative to thickness Tnr6 of semiconductor structure 631 to tune the performance of transistor structure 600. In some embodiments, thickness Tnr5 is increased by thickness delta Td relative to reference thickness TnrR. For example, semiconductor structure 631 may have a thickness of TnrR (i.e., Tnr6=TnrR) and semiconductor structure 632 may have a thickness of TnrR plus thickness delta Td (i.e., Tnr5=TnrR+Td) such that thicknesses Tnr5 is not less than 3 angstroms greater than thickness Tnr6. In some embodiments, thicknesses Tnr5 is not less than 5 angstroms greater than thicknesses Tnr6. In some embodiments, thicknesses Tnr5 is not less than 7 angstroms greater than thicknesses Tnr6. In some embodiments, thicknesses Tnr5 is not less than 3 angstroms and not more than 12 angstroms greater than thicknesses Tnr6. In some embodiments, thicknesses Tnr5 is not less than 3 angstroms and not more than 15 angstroms greater than thicknesses Tnr6. In some embodiments, thicknesses Tnr5 is not less than 5 angstroms and not more than 10 angstroms greater than thicknesses Tnr6.

FIG. 7 illustrates a cross-sectional side view of a transistor structure 700 with a lower-most semiconductor structure having an increased thickness relative to other semiconductor structures of stack 124 of semiconductor structures 131, 132, 133, 134, 135, 136, in accordance with at least some embodiments of the present disclosure. As discussed, stack 124 may have any number of semiconductor structures such as 2 to 8 semiconductor structures or more. FIG. 7 illustrates an example with six semiconductor structures 131, 132, 133, 134, 135, 136 with semiconductor structure 136 being longer than any other of semiconductor structures 131, 132, 133, 134, 135, and correspondingly, semiconductor structure 136 having an increased tuned thickness. This is similar to the example of FIG. 2.

Source-to-drain lengths Lnr1, Lnr2, Lnr3, Lnr4, Lnr5, Lnr6 may be any lengths discussed herein above. In some embodiments, bottom-most semiconductor structure 136 has a greater source-to-drain length Lnr6 than any of source-to-drain lengths Lnr1, Lnr2, Lnr3, Ln4, Lnr5. In some embodiments, bottom-most semiconductor structure 136 has a greatest source-to-drain length Lnr6 that is not less than 5%, not less than 10%, or not less than 20% greater than any of source-to-drain lengths Lnr1, Lnr2, Lnr3, Ln4, Lnr5. In response to this predictably fabricated length difference, the thickness Tnr6 of bottom-most semiconductor structure 136 is increased by thickness delta Td as discussed herein.

In the context of FIG. 7, the thickness Tnr6 of bottom-most semiconductor structure 136 is increased due to it having the longest source-to-drain length Lnr6. However, any of semiconductor structures 131, 132, 133, 134, 135, 136 may have increased thicknesses in response to their length being longer or shorter than others of semiconductor structures 131, 132, 133, 134, 135, 136. As discussed, such electrical tuning may be based on balancing current across semiconductor structures 131, 132, 133, 134, 135, 136 and/or other concerns such as leakage, source/drain to semiconductor resistance differences across semiconductor structures 131, 132, 133, 134, 135, 136, proximity to source/drain contact, and others.

In some embodiments, any of semiconductor structures 131, 132, 133, 134, 135, 136 may have a thickness that is increased or decreased by 3 to 15 angstroms relative to others of semiconductor structures 131, 132, 133, 134, 135, 136 based on being, for example, 5%, 10%, or 20% longer or shorter (i.e., in source-to-drain length) than others of semiconductor structures 131, 132, 133, 134, 135, 136 in any combination. Furthermore, such increase(s) or decrease(s) may be made in any combination across semiconductor structures 131, 132, 133, 134, 135, 136. It is noted that multiple increases, multiple decreases, or a combination thereof may be limited across stack 124 to two increase, two decreases, or one increase and one decrease for a total of 2*Td difference between any two of semiconductor structures 131, 132, 133, 134, 135, 136 due to the limited benefits of thickness differences as discussed above. However, with smaller thickness differences Td, multiples of three or four of thickness differences Td may be used between any of semiconductor structures 131, 132, 133, 134, 135, 136.

As discussed, any of semiconductor structures 131, 132, 133, 134, 135, 136 may have a thickness that is increased or decreased relative to others of semiconductor structures 131, 132, 133, 134, 135, 136 based on being longer or shorter than others of semiconductor structures 131, 132, 133, 134, 135, 136 in any combination. In some embodiments, top-most and bottom-most semiconductor structures 131, 136 have a thickness of not less than 3 to 15 angstroms greater than any of semiconductor structures 132, 133, 134, 135. In some embodiments, middle semiconductor structures 133, 134 have a thickness of not less than 3 to 15 angstroms greater than any of semiconductor structures 131, 132, 135, 136. In some embodiments, top-most and bottom-most semiconductor structures 131, 136 have a thickness of not less than 3 to 15 angstroms greater than semiconductor structures 133, 134 and semiconductor structures 132, 135 have a thickness of not less than 3 to 15 angstroms less than semiconductor structures 133, 134. As will be appreciated may combinations of such thickness variations are available to stack 124.

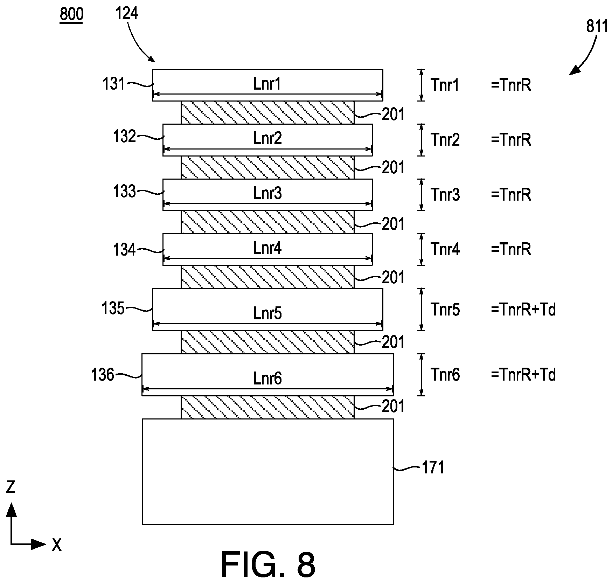

FIG. 8 illustrates a cross-sectional side view of a transistor structure 800 with two lower-most semiconductor structures having an increased thickness relative to other semiconductor structures of stack 124 of semiconductor structures 131, 132, 133, 134, 135, 136, in accordance with at least some embodiments of the present disclosure. Although FIG. 8 illustrates an example with six semiconductor structures 131, 132, 133, 134, 135, 136, any number of semiconductor structures may be used. In the context of transistor structure 800, bottom-most semiconductor structures 135, 136 have an increased tuned thickness.

As discussed, turning the thicknesses of semiconductor structures 131, 132, 133, 134, 135, 136 may be based on the differences of source-to-drain lengths of semiconductor structures 131, 132, 133, 134, 135, 136 and the electrical characteristics. In the context of FIG. 8, bottom-most semiconductor structure 136 has a greatest source-to-drain length Lnr6 that is not less than 5%, not less than 10%, or not less than 20% greater than any of source-to-drain lengths Lnr1, Lnr2, Lnr3, Ln4, Lnr5. Furthermore, second-to-bottom-most semiconductor structure 135 has a source-to-drain length Lnr5 that is less than that of Lnr6 and not greater than all of source-to-drain lengths Lnr1, Lnr2, Lnr3, Ln4. For example, source-to-drain length Lnr5 may be less than or equal to any of source-to-drain lengths Lnr1, Lnr2, Lnr3, Ln4 such as source-to-drain length Lnr1. In this context, thickness Tnr5 of semiconductor structure 135 may be increases to offload current flow from others of semiconductor structures 131, 132, 133, 134 and toward semiconductor structure 136. Although illustrated with respect to semiconductor structures 135, 136 having increased thicknesses, in other examples, the thickness of semiconductor structure 136 and any of semiconductor structures 131, 132, 133, 134 are increased.

For example, source-to-drain lengths Lnr1, Lnr2, Lnr3, Lnr4, Lnr5, Lnr6 may be any lengths discussed herein above. and, in some embodiments, bottom-most semiconductor structure 136 has a greater source-to-drain length Lnr6 than any of source-to-drain lengths Lnr1, Lnr2, Lnr3, Ln4, Lnr5. For example, bottom-most semiconductor structure 136 may have a greatest source-to-drain length Lnr6 that is not less than 5%, not less than 10%, or not less than 20% greater than any of source-to-drain lengths Lnr1, Lnr2, Lnr3, Ln4, Lnr5. The thickness Tnr6 of bottom-most semiconductor structure 136 is then increased along with the thickness of one of semiconductor structures 131, 132, 133, 134, 135 as discussed above.

In the context of FIG. 7, the thickness Tnr6 of bottom-most semiconductor structure 136 is increased due to it having the longest source-to-drain length Lnr6. However, any of semiconductor structures 131, 132, 133, 134, 135, 136 may have increased thicknesses in response to their length being longer or shorter than others of semiconductor structures 131, 132, 133, 134, 135, 136. As discussed, such electrical tuning may be based on balancing current across semiconductor structures 131, 132, 133, 134, 135, 136 and/or other concerns such as leakage, source/drain to semiconductor resistance differences across semiconductor structures 131, 132, 133, 134, 135, 136, proximity to source/drain contact, and others.

Discussion now turns to fabrication of any transistor structures discussed herein. Notably, the tuned thicknesses are formed at the start of fabrication based on known etch profiles that occur later in the fabrication process.

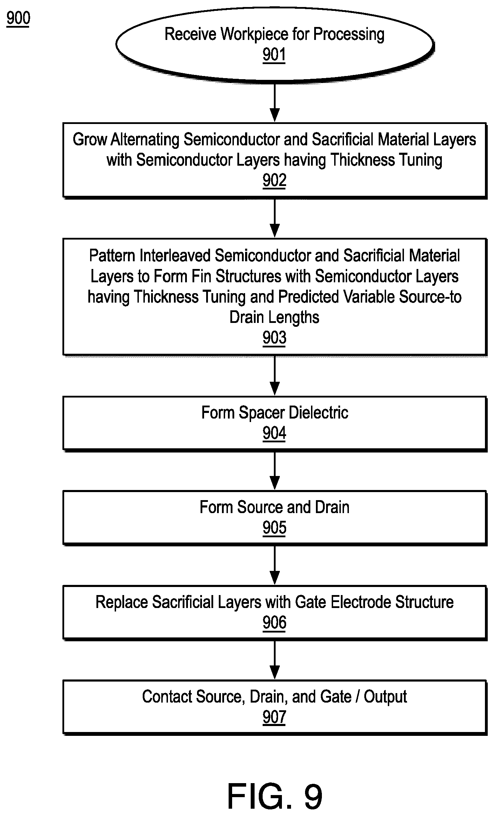

FIG. 9 is a flow diagram illustrating exemplary methods 900 for forming transistor structures with a stack of semiconductor structures having tuned thicknesses, arranged in accordance with at least some implementations of the present disclosure. For example, methods 900 may be implemented to fabricate transistor structures 100, 1500 or any transistor structure having any tuned thickness stack discussed herein. In the illustrated implementation, methods 900 may include one or more operations as illustrated by operations 901-907. However, embodiments herein may include additional operations, certain operations being omitted, or operations being performed out of the order provided.

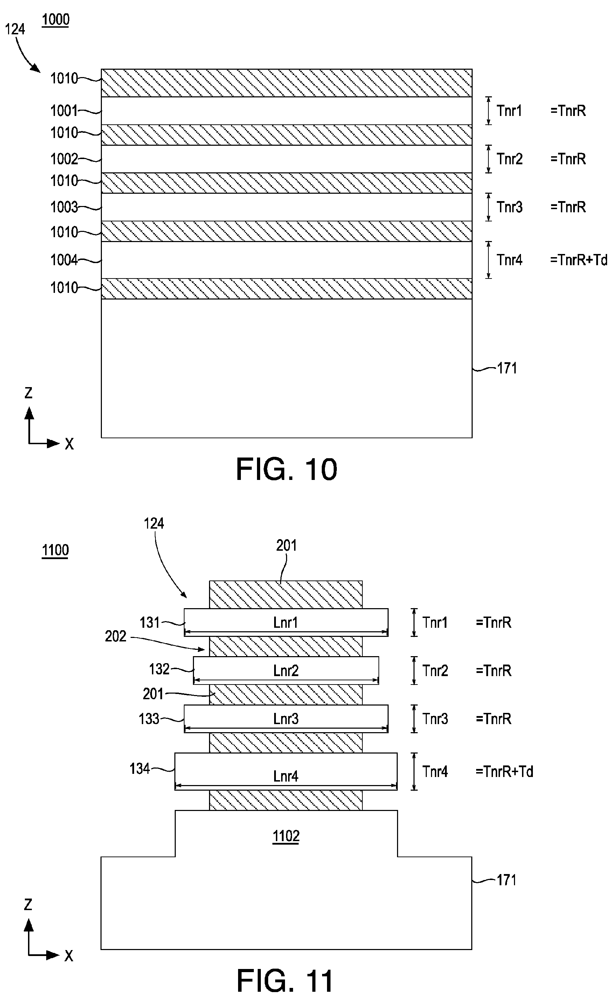

FIGS. 10, 11, 12, 13, 14, and 15 are cross-sectional side views of example transistor structures as particular fabrication operations of methods 900 are performed, arranged in accordance with at least some implementations of the present disclosure. For example, methods 900 may be deployed to fabricate the transistor structures of FIGS. 10, 11, 12, 13, 14, and 15 or any other transistor structures discussed herein. The fabricated transistor structures may have nay characteristics discussed with respect to transistor structures 100, 200, 300, 400, 500, 600, 700, 800.

Processing begins at operation 901, where a workpiece such as a substrate is received for processing. The substrate may include any suitable substrate as discussed herein such as a silicon wafer or the like. In some embodiments, the substrate includes underlying devices or electrical interconnects. In some embodiments, substrate 171 may be received for processing.

Processing continues at operation 902, where alternating layers of semiconductor material layers and sacrificial layers are formed over the workpiece or substrate. The alternating layers of semiconductor material layers and sacrificial layers may be formed using any suitable technique or techniques such as epitaxial growth techniques, deposition techniques or the like. The semiconductor material layers and sacrificial layers may have any thickness characteristics discussed with respect to FIGS. 2-8. In some embodiments, semiconductor material layer thicknesses are tuned based on growth or deposition conditions such as adjusting the growth or deposition times used when forming the semiconductor material layers.

Referring now to FIG. 10, an example transistor structure 1000 includes substrate 171 (e.g., a transistor structure work piece), and a stack 124 of semiconductor material layers 1001, 1002, 1003, 1004 alternating or interleaved with sacrificial layers 1010. Stack 124 of semiconductor material layers 1001, 1002, 1003, 1004 and sacrificial layers 1010 may be formed using any suitable technique or techniques such as those discussed with respect to operation 902. Notably, semiconductor material layers 1001, 1002, 1003, 1004 and sacrificial layers 1010 are bulk layers that may be later patterned such that the patterning forms predictable source-to-drain lengths as discussed. In some embodiments, semiconductor material layers 1001, 1002, 1003, 1004 are silicon such as monocrystalline silicon and sacrificial layers 1010 are silicon germanium, however other material systems may be used.

Notably, the thicknesses Tnr1, Tnr2, Tnr3, Tnr4 of semiconductor material layers 1001, 1002, 1003, 1004 are tuned to fabricate transistor structure 200. However, any thickness discussed herein may be deployed. As shown, semiconductor material layers 1001, 1002, 1003, 1004 and sacrificial layers 1010 are formed over substrate 171.

Substrate 171 may include any suitable material or materials and, in some embodiments, substrate 171 includes a material or materials having the same or a similar composition with respect to semiconductor material layers 1001, 1002, 1003, 1004. In some embodiments, substrate 171 and semiconductor material layers 1001, 1002, 1003, 1004 include a Group IV material (e.g., silicon). In some embodiments, substrate 171 and semiconductor material layers 1001, 1002, 1003, 1004 include a substantially monocrystalline material. In some embodiments, substrate 171 includes a buried insulator layer (e.g., SiO₂), for example, of a semiconductor-on-insulator (SOI) substrate and/or isolation insulator regions and the like. Semiconductor material layers 1001, 1002, 1003, 1004 may include any number of layers for the formation of semiconductor structures, channel semiconductors, nanoribbons, or nanowires over substrate 171 such as two, three, four, five, six, seven, eight or more layers with even numbers of semiconductor material layers 1001, 1002, 1003, 1004 typically being deployed. Semiconductor material layers 1001, 1002, 1003, 1004 are separated and interleaved with sacrificial layers 1010, which will later be removed and replaced by one or more gate structures inclusive of, for example, gate dielectric materials and gate electrode materials.

Returning to FIG. 9, processing continues at operation 903, where the alternating layers of semiconductor material layers and sacrificial layers are patterned to form a fin structure. Such patterning may be performed using any suitable technique or techniques such as lithography and etch techniques. As discussed, when patterned, the resultant semiconductor structures or nanoribbons have predictably differing lengths due at least in part to the patterning profile (e.g., etch profile). In some embodiments, the patterning includes multiple etches such as one or two etches to define the fin critical dimensions of the semiconductor material layers and a recess etch to recess the sacrificial layer for formation of a dielectric spacer. The dielectric may isolate source and drain from gate, which are formed subsequently in the process.

FIG. 11 illustrates an example transistor structure 1100 similar to transistor structure 1000 after patterning processing to form stack 124 including semiconductor structures 131, 132, 133, 134 and sacrificial layers 201, which may have any characteristics discussed above inclusive of recesses 202. As discussed, stack 124 may be patterned from semiconductor material layers 1001, 1002, 1003, 1004 and sacrificial layers 1010 using one or more lithography and etch patterning operations. Also as shown, formation of semiconductor material layers 1001, 1002, 1003, 1004 may form a sub-fin portion 1102.

Returning to FIG. 9, processing continues at operation 904, where a dielectric spacer is formed adjacent to the sacrificial layers, for eventual isolation of gate structures from source and drain materials. The dielectric spacer may be formed using any suitable technique or techniques such as deposition and etch techniques.

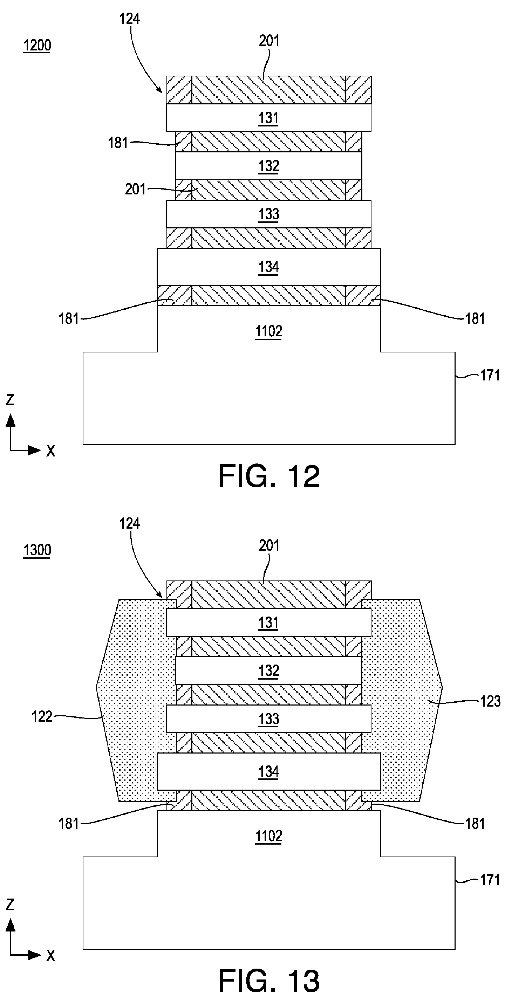

FIG. 12 illustrates an example transistor structure 1200 similar to transistor structure 1100 after formation of isolation material 181. In FIGS. 12-15, the illustration of thicknesses TnrX and source-to-drain lengths LnrX are not shown for the sake of clarity but such dimensions are substantially maintained in transistor structure 1200 and subsequent transistor structures. Isolation material 181 may also be characterized as a dielectric spacer, spacer, or spacer material as it spaces an eventual gate structure, which will replace sacrificial layers 201, from eventual source structure 122 and drain structure 123. Isolation material 181 may be any suitable dielectric material such as silicon oxide, silicon nitride, silicon oxynitride, or the like.

Returning to FIG. 9, processing continues at operation 905, where epitaxial source and drain materials are deposited via growth from the exposed portions of the patterned semiconductor structures. In some embodiments, an epitaxial nucleation layer may be deposited, followed by bulk deposition. The source and drain materials may be any suitable materials such as doped silicon, doped silicon germanium, or the like. The epitaxial source and drain materials may be deposited using any suitable technique or techniques such as chemical vapor deposition including dopant materials.

FIG. 13 illustrates an example transistor structure 1300 similar to transistor structure 1200 after formation of source structure 122 and drain structure 123. As discussed, source structure 122 and drain structure 123 may be epitaxial bodies such as doped epitaxial silicon or doped epitaxial silicon and germanium (SiGe), for example. As discussed, formation of source structure 122 and drain structure 123 provide interfaces between source-to-drain lengths of semiconductor structures 131, 132, 133, 134 (refer to FIG. 1B).

Returning to FIG. 9, processing continues at operation 906, where the sacrificial materials deposited at operation 902 and patterned at operation 903 are removed and replaced by a gate structure, which may include a gate dielectric material on at least portions of the semiconductor structures and a gate electrode (e.g., gate metal) on the gate dielectric material. The sacrificial materials may be removed using any suitable technique or techniques such as wet etch techniques. The gate dielectric material may be formed using, for example, conformal deposition, and the gate electrode may be formed by conformal deposition (of a work function metal) followed by metal fill. However, other fabrication techniques may be used.

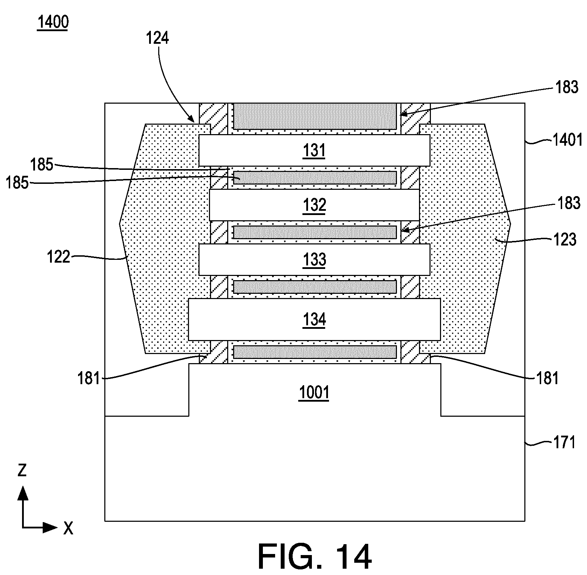

FIG. 14 illustrates an example transistor structure 1400 similar to transistor structure 1300 after formation of isolation material 1401 and gate structure 183, which includes gate dielectric layer 184 and a gate electrode 185. Isolation material 1401 may be silicon oxide or other dielectric material. In some embodiments, gate structure 183 includes a gate dielectric layer 184 that is or includes aluminum oxide, hafnium oxide, zirconium oxide, titanium silicon oxide, hafnium silicon oxide, or silicon nitride. In some embodiments, gate electrode 185 includes a work function layer of platinum, nickel, titanium nitride, or tantalum nitride and a fill metal such as tungsten. However, other material systems may be used.

Returning to FIG. 9, processing continues at operation 907, where the source and drain materials and gate structures are contacted by metal contacts using any suitable technique or techniques such as patterning and metal deposition processing as is known in the art. Furthermore, at operation 907, additional fabrication may be completed and the resultant structure may be output. Such processing may include additional frontside metallization, backside metallization, additional backend processing, dicing, packaging, assembly, and so on. The resultant device (e.g., integrated circuit die) may then be implemented in any suitable form factor device such as a laptop, a netbook, a notebook, an ultrabook, a smartphone, a tablet, a personal digital assistant, an ultra-mobile PC, a mobile phone, a desktop computer, a server, a printer, a scanner, a monitor, a set-top box, an entertainment control unit, a digital camera, a portable music player, a digital video recorder, or the like.

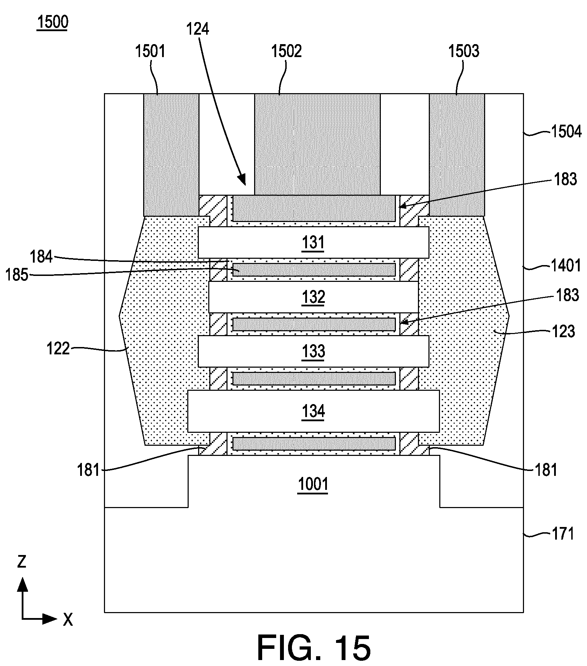

FIG. 15 illustrates an example transistor structure 1500 similar to transistor structure 1400 after the formation of isolation material 1504, gate contact 1502, source contact 1501, and drain contact 1503. The formation of isolation material 1504, gate contact 1502, source contact 1501, and drain contact 1503 may be performed using operations known in the art such as bulk isolation followed by planarization to form isolation material 1504, and lithography patterning of vias and via fill and optional planarization to form gate contact 1502, source contact 1501, and drain contact 1503. Such components may include any suitable materials. For example, isolation material 1504 may be silicon oxide, and gate contact 1502, source contact 1501, and drain contact 1503 may include a liner material such as titanium nitride and a fill metal such as tungsten. However, other material systems may be used.

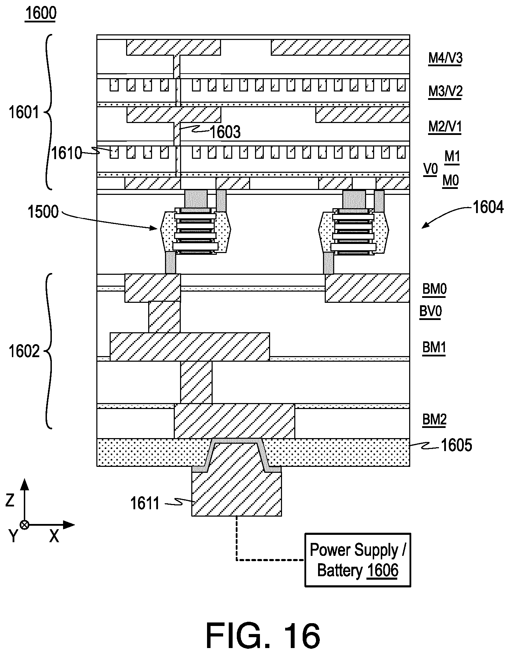

FIG. 16 illustrates a cross-sectional side view of transistor structure 1500 having a stack of semiconductor structures with tuned thicknesses incorporated in an integrated circuit die 1600, in accordance with at least some embodiments of the present disclosure. As shown, transistor structure 1500 or any other transistor structure discussed herein may be incorporated in integrated circuit (IC) die 1600 having frontside metallization layers 1601 (or frontside interconnect layers) and backside metallization layers 1602 (or backside interconnect layers). Frontside metallization layers 1601 and backside metallization layers 1602 may be formed using any suitable technique or techniques such as dual damascene techniques, single damascene techniques, subtractive metallization patterning techniques, or the like.

For example, interconnectivity, signal routing, power-delivery, and the like may be provided by frontside metallization layers 1601. Adjacent metallization layers, such as metallization interconnects 1610, are interconnected by vias, such as vias 1603, that may be characterized as part of the metallization layers or between the metallization layers. As shown, in some embodiments, frontside metallization layers 1601 are formed over and immediately adjacent transistor structure 1500. In the illustrated example, frontside metallization layers 1601 include M0, V0, M1, M2/V1, M3/V2, and M4/V3. However, frontside metallization layers 1601 may include any number of metallization layers such as six, eight, or more metallization layers.

Similarly, backside metallization layers 1602, may be used for power delivery and any other suitable electrical connectivity. In the illustrated example, package level interconnects 1611 are provided on or over a device backside as bumps over a passivation layer 1605. However, package level interconnects 1611 may be provided using any suitable interconnect structures such as bond pads, solder bumps, etc. As shown, in some embodiments, backside metallization layers 1602 are formed over and immediately adjacent transistor structure 1500 such that a device layer 1604 including transistor structure 1500 is between frontside metallization layers 1601 and backside metallization layers 1602. In the illustrated example, backside metallization layers 1602 include BM0, BM1, and BM2 with intervening via layers. However, backside metallization layers 1602 may include any number of metallization layers such as three, four, or more metallization layers.

In some embodiments, transistor structure 1500 is deployed in a monolithic integrated circuit (IC) die 1600 including a gate-all-around field effect transistor structure (e.g., a GAA-FET), the GAA-FET transistor structure including any of the discussed components and characteristics. As shown, a power supply 1606 may be coupled to IC die 1600, such that power supply 1606 may include a battery, voltage converter, power supply circuitry, or the like.

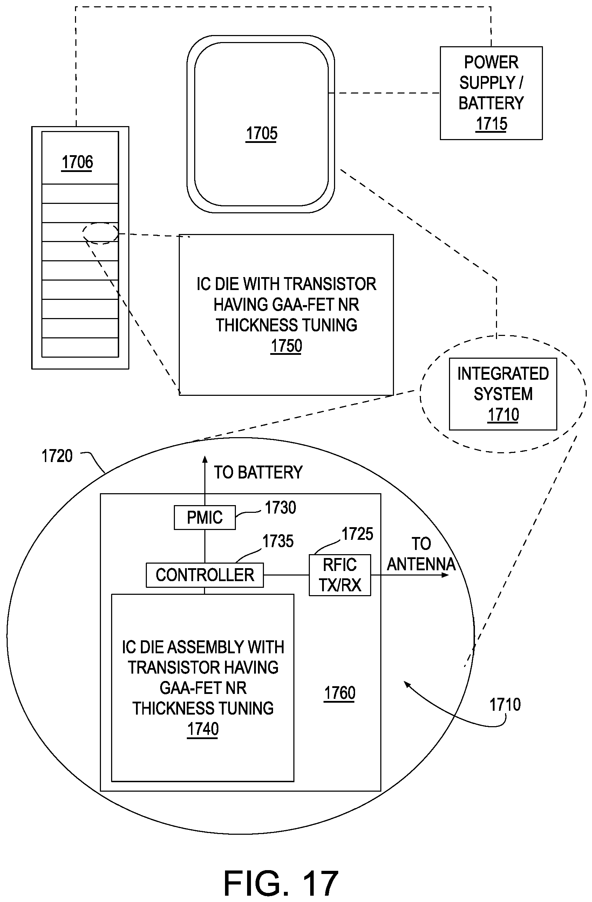

FIG. 17 illustrates exemplary systems employing an integrated circuit assembly including an integrated circuit die having a transistor structure with a stack of semiconductor structures with tuned thicknesses, in accordance with some embodiments. The system may be a mobile computing platform 1705 and/or a data server machine 1706, for example. Either may employ a component assembly including an IC die having a transistor structure with a stack of semiconductor structures with tuned thicknesses as described elsewhere herein. Server machine 1706 may be any commercial server, for example including any number of high-performance computing platforms disposed within a rack and networked together for electronic data processing, which in the exemplary embodiment includes an IC die assembly 1750 with an IC die having a transistor structure with a stack of semiconductor structures with tuned thicknesses as described elsewhere herein. Mobile computing platform 1705 may be any portable device configured for each of electronic data display, electronic data processing, wireless electronic data transmission, or the like. For example, mobile computing platform 1705 may be any of a tablet, a smart phone, a laptop computer, etc., and may include a display screen (e.g., a capacitive, inductive, resistive, or optical touchscreen), a chip-level or package-level integrated system 1710, and a battery 1715. Although illustrated with respect to mobile computing platform 1705, in other examples, chip-level or package-level integrated system 1710 and a battery 1715 may be implemented in a desktop computing platform, an automotive computing platform, an internet of things platform, or the like. As discussed below, in some examples, the disclosed systems may include a sub-system 1760 such as a system on a chip (SOC) or an integrated system of multiple ICs, which is illustrated with respect to mobile computing platform 1705.

Whether disposed within integrated system 1710 illustrated in expanded view 1720 or as a stand-alone packaged device within data server machine 1706, sub-system 1760 may include memory circuitry and/or processor circuitry 1740 (e.g., RAM, a microprocessor, a multi-core microprocessor, graphics processor, etc.), a power management integrated circuit (PMIC) 1730, a controller 1735, and a radio frequency integrated circuit (RFIC) 1725 (e.g., including a wideband RF transmitter and/or receiver (TX/RX)). As shown, one or more IC dies, such as memory circuitry and/or processor circuitry 1740 may be assembled and implemented such that one or more have an IC die having a transistor structure with a stack of semiconductor structures with tuned thicknesses as described herein. In some embodiments, RFIC 1725 includes a digital baseband and an analog front end module further comprising a power amplifier on a transmit path and a low noise amplifier on a receive path). Functionally, PMIC 1730 may perform battery power regulation, DC-to-DC conversion, etc., and so has an input coupled to battery 1715, and an output providing a current supply to other functional modules. As further illustrated in FIG. 17, in the exemplary embodiment, RFIC 1725 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Memory circuitry and/or processor circuitry 1740 may provide memory functionality for sub-system 1760, high level control, data processing and the like for sub-system 1760. In alternative implementations, each of the SOC modules may be integrated onto separate ICs coupled to a package substrate, interposer, or board.

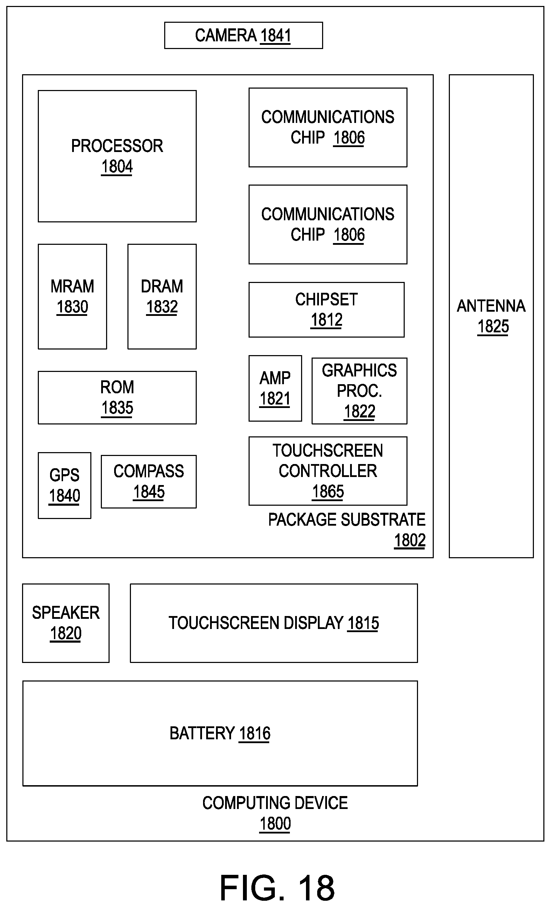

FIG. 18 is a functional block diagram of an electronic computing device 1800, in accordance with some embodiments. For example, device 1800 may, via any suitable component therein, employ a transistor structure with a stack of semiconductor structures with tuned thicknesses in accordance with any embodiments described elsewhere herein. Device 1800 further includes a motherboard or package substrate 1802 hosting a number of components, such as, but not limited to, a processor 1804 (e.g., an applications processor). Processor 1804 may be physically and/or electrically coupled to package substrate 1802. In some examples, processor 1804 is within an IC assembly that includes an IC die having a transistor structure with a stack of semiconductor structures with tuned thicknesses as described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1806 may also be physically and/or electrically coupled to the package substrate 1802. In further implementations, communication chips 1806 may be part of processor 1804. Depending on its applications, computing device 1800 may include other components that may or may not be physically and electrically coupled to package substrate 1802. These other components include, but are not limited to, volatile memory (e.g., DRAM 1832), non-volatile memory (e.g., ROM 1835), flash memory (e.g., NAND or NOR), magnetic memory (MRAM 1830), a graphics processor 1822, a digital signal processor, a crypto processor, a chipset 1812, an antenna 1825, touchscreen display 1815, touchscreen controller 1865, battery 1816, audio codec, video codec, power amplifier 1821, global positioning system (GPS) device 1840, compass 1845, accelerometer, gyroscope, speaker 1820, camera 1841, and mass storage device (such as hard disk drive, solid-state drive (SSD), compact disk (CD), digital versatile disk (DVD), and so forth, or the like.

Communication chips 1806 may enable wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1806 may implement any of a number of wireless standards or protocols, including, but not limited to, those described elsewhere herein. As discussed, computing device 1800 may include a plurality of communication chips 1806. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the invention is not limited to the embodiments so described, but can be practiced with modification and alteration without departing from the scope of the appended claims. For example the above embodiments may include specific combinations of features as further provided below.

The following pertains to exemplary embodiments.

In one or more first embodiments, an apparatus comprises a source and a drain, a stack of semiconductor structures between the source and the drain, such that a first of the semiconductor structures has a first thickness, a second of the semiconductor structures has a second thickness, and the first thickness is not less than three angstroms greater than the second thickness, and a gate structure adjacent and between the stack of semiconductor structures.

**In** one or more second embodiments, further to the first embodiments, the first of the semiconductor structures has a first source-to-drain length and the second of the semiconductor structures has a second source-to-drain length, and the first source-to-drain length is greater than the second source-to-drain length.

**In** one or more third embodiments, further to the first or second embodiments, the first source-to-drain length is not less than 10% greater than the second source-to-drain length and the first thickness is not less five angstroms greater than the second thickness.

**In** one or more fourth embodiments, further to the first through third embodiments, the first of the semiconductor structures is a bottom-most semiconductor structure of the stack of semiconductor structures.

In one or more fifth embodiments, further to the first through fourth embodiments, the first of the semiconductor structures has a first source-to-drain length and the second of the semiconductor structures has a second source-to-drain length, and the second source-to-drain length is greater than the first source-to-drain length.

In one or more sixth embodiments, further to the first through fifth embodiments, the second source-to-drain length is not less than 10% greater than the first source-to-drain length and the first thickness is not less five angstroms greater than the second thickness.

In one or more seventh embodiments, further to the first through sixth embodiments, the second of the semiconductor structures is a bottom-most semiconductor structure of the stack of semiconductor structures and the first of the semiconductor structures is a top-most semiconductor structure of the stack of semiconductor structures.

In one or more eighth embodiments, further to the first through seventh embodiments, a third of the semiconductor structures has a third source-to-drain length and a third thickness, the second source-to-drain length is not less than 10% greater than the third source-to-drain length and the second thickness is not less three angstroms less than the third thickness, and the third of the semiconductor structures is immediately below the first of the semiconductor structures.

In one or more ninth embodiments, further to the first through eighth embodiments, each of the semiconductor structures comprises silicon, and the source and the drain are epitaxial to the semiconductor structures.

In one or more tenth embodiments, further to the first through ninth embodiments, the apparatus further comprises an integrated circuit (IC) die comprising the source, the drain, the stack of semiconductor structures, and the gate structure, and a power supply coupled to the IC die.

In one or more eleventh embodiments, an apparatus comprises a source structure and a drain structure, a stack of semiconductor structures aligned in a vertical direction and extending between interfaces with the source structure and the drain structure, a first of the semiconductor structures having a first source-to-drain length of not less than 10% greater than a second source-to-drain length of a second of the semiconductor structures, such that the first of the semiconductor structures has a first thickness of not less than five angstroms greater than of a second thickness of the second of the semiconductor structures, and a gate structure adjacent to the stack of semiconductor structures.

In one or more twelfth embodiments, further to the eleventh embodiments, the first of the semiconductor structures is a bottom-most semiconductor structure of the stack of semiconductor structures.

In one or more thirteenth embodiments, further to the eleventh or twelfth embodiments, the first thickness is not less than seven angstroms greater than the second thickness.

In one or more fourteenth embodiments, further to the eleventh through thirteenth embodiments, the second thickness is not less than 75 angstroms and not greater than 100 angstroms.

In one or more fifteenth embodiments, further to the eleventh through fourteenth embodiments, the first of the semiconductor structures is above the second of the semiconductor structures in the stack of semiconductor structures.

In one or more sixteenth embodiments, further to the eleventh through fifteenth embodiments, the apparatus further comprises an integrated circuit (IC) die comprising the source, the drain, the stack of semiconductor structures, and the gate structure, and a power supply coupled to the IC die.

In one or more seventeenth embodiments, a method comprises receiving a multilayer stack comprising a plurality of semiconductor material layers interleaved with a plurality of sacrificial layers, such that a first of the semiconductor material layers has a first thickness of not less than five angstroms greater than a second thickness of a second of the semiconductor material layers, etching the multilayer stack to form a fin structure, growing a source structure and a drain structure from the semiconductor material layers of the fin structure, such that the first of the semiconductor material layers has a first source-to-drain length that is greater than a second source-to-drain length of the second of the semiconductor material layers, and replacing the sacrificial layers with a gate structure coupled to the semiconductor material layers.

In one or more eighteenth embodiments, further to the seventeenth embodiments, the first of the semiconductor material layers is a bottom-most semiconductor material layer of the semiconductor material layers, and the first thickness is not less than seven angstroms greater than the second thickness.

In one or more nineteenth embodiments, further to the seventeenth or eighteenth embodiments, the first source-to-drain length is not less than 20% greater than the second source-to-drain length.

In one or more twentieth embodiments, further to the seventeenth through nineteenth embodiments, the first of the semiconductor material layers is above the second of the semiconductor material layers.

It will be recognized that the invention is not limited to the embodiments so described, but can be practiced with modification and alteration without departing from the scope of the appended claims. For example, the above embodiments may include specific combination of features. However, the above embodiments are not limited in this regard and, in various implementations, the above embodiments may include the undertaking only a subset of such features, undertaking a different order of such features, undertaking a different combination of such features, and/or undertaking additional features than those features explicitly listed. The scope of the invention should, therefore, be determined with reference to the appended claims, along with the full scope of equivalents to which such claims are entitled.

## Claims

1. An apparatus, comprising:
a source and a drain;
a stack of semiconductor structures between the source and the drain, wherein a first of the semiconductor structures has a first thickness, a second of the semiconductor structures has a second thickness, and the first thickness is not less than three angstroms greater than the second thickness; and
a gate structure adjacent and between the stack of semiconductor structures.

2. The apparatus of claim **1,** wherein the first of the semiconductor structures has a first source-to-drain length and the second of the semiconductor structures has a second source-to-drain length, and wherein the first source-to-drain length is greater than the second source-to-drain length.

3. The apparatus of claim 2, wherein the first source-to-drain length is not less than 10% greater than the second source-to-drain length and the first thickness is not less five angstroms greater than the second thickness.

4. The apparatus of claim 2 or 3, wherein the first of the semiconductor structures is a bottom-most semiconductor structure of the stack of semiconductor structures.

5. The apparatus of one of the previous claims, wherein the first of the semiconductor structures has a first source-to-drain length and the second of the semiconductor structures has a second source-to-drain length, and wherein the second source-to-drain length is greater than the first source-to-drain length.

6. The apparatus of claim 5, wherein the second source-to-drain length is not less than 10% greater than the first source-to-drain length and the first thickness is not less five angstroms greater than the second thickness.

7. The apparatus of claim 5 or 6, wherein the second of the semiconductor structures is a bottom-most semiconductor structure of the stack of semiconductor structures and the first of the semiconductor structures is a top-most semiconductor structure of the stack of semiconductor structures.

8. The apparatus of any one of claims 5 to 7, wherein a third of the semiconductor structures has a third source-to-drain length and a third thickness, wherein the second source-to-drain length is not less than 10% greater than the third source-to-drain length and the second thickness is not less three angstroms less than the third thickness, and wherein the third of the semiconductor structures is immediately below the first of the semiconductor structures.

9. The apparatus of any one of claims 1 to 8, wherein each of the semiconductor structures comprises silicon, and wherein the source and the drain are epitaxial to the semiconductor structures.

10. The apparatus of any one of claims 1 to 9, further comprising:
an integrated circuit (IC) die comprising the source, the drain, the stack of semiconductor structures, and the gate structure; and
a power supply coupled to the IC die.

11. A method, comprising:
receiving a multilayer stack comprising a plurality of semiconductor material layers interleaved with a plurality of sacrificial layers, wherein a first of the semiconductor material layers has a first thickness of not less than five angstroms greater than a second thickness of a second of the semiconductor material layers;
etching the multilayer stack to form a fin structure;
growing a source structure and a drain structure from the semiconductor material layers of the fin structure, wherein the first of the semiconductor material layers has a first source-to-drain length that is greater than a second source-to-drain length of the second of the semiconductor material layers; and
replacing the sacrificial layers with a gate structure coupled to the semiconductor material layers.

12. The method of claim 11, wherein the first of the semiconductor material layers is a bottom-most semiconductor material layer of the semiconductor material layers, and wherein the first thickness is not less than seven angstroms greater than the second thickness.

13. The method of claim 12, wherein the first source-to-drain length is not less than 20% greater than the second source-to-drain length.

14. The method of claim 11, 12 or 13, wherein the first of the semiconductor material layers is above the second of the semiconductor material layers.

15. The method of claim 14, wherein the second of the semiconductor material layers is a bottom-most semiconductor material layer of the stack of semiconductor material layers and the first of the semiconductor material layers is a top-most semiconductor material layer of the stack of semiconductor material layers.
